# EUROPEAN PATENT APPLICATION

(11) **EP 1 253 429 A2**
(43) Date of publication of application: **30.10.2002**
(21) Application number: 02252760.0
(22) Date of filing: 18.04.2002
(51) Int. Cl.: G01R 29/08

(54) **Electromagnetic emission source identification apparatus and associated method, computer device, and computer software program product**

(30) Priority: 26.04.2001 US 842834
(71) Applicant: MCNC, Research Triangle Park, North Carolina 27709 (US)
(72) Inventor: Swartz, John C., Durham, N. Carolina 27713 (US); Roberson, Mark W., Cary, N. Carolina 27511 (US); Vargas-Hurlston, Sarah, Durham, N. Carolina 27707 (US); Williams, Charles Kenneth, Raleigh, N. Carolina 27608 (US); Mancusi, Joseph E., Durham, N. Carolina 27713 (US)
(74) Representative: Johnstone, Douglas Ian

(57) **Abstract**

An electromagnetic emission source identification apparatus (100) comprising a sensor device (200), a data transmitter (400), and a computer (600). The sensor device (200) senses electromagnetic emission data from a source (700), which is transmitted to the computer (600) by the transmitter (400) before or after conversion to digital emission data. The computer (600) processes the digital emission data so as to determine an identification indicator, an operational characteristic indicator, and/or an accessory characteristic indicator corresponding to the source (700) and then compares to this,corresponding indicators of each of a plurality of known sources in a database and determines a best-match therebetween. Associated methods as well as an associated computer device and computer software program product are also provided.

## Description

The present invention relates to identification apparatuses and, more particularly, to an apparatus and associated method, including an associated computer device and computer software program product, for identifying a source and the operational or other characteristics thereof based on the electromagnetic emission from the source.

Many modern machinery items produce electromagnetic emissions to varying degrees. For example, an internal combustion engine typically includes an ignition system which requires large electrical currents during short time intervals through the spark plug system in order for the engine to operate. Electrical current also flows through associated components and systems such as alternators, pumps, and electronics. Each electrical path associated with these components and systems has current flow between a positive and a negative terminal, such as between +12V and ground, typically through a component to chassis connection. Such current flow produces a magnetic field as described by Ampere's Law. However, because of differences in the design of the electronics and electrical distribution systems of different vehicles, as well as differences in equipment condition and loading, the current in the system will vary with time. That is, a time-varying current density will generate an electromagnetic field with a correlated time variation. Thus, since each vehicle or type of vehicle will have a similar time-varying current profile, the radiated electromagnetic waves therefrom will have a distinctive "signature" corresponding to the generated currents. Accordingly, vehicles or other sources emanating an electromagnetic field may be detected and identified using this basic principle.

However, this basic concept may be further complicated by various factors which may limit the practicality of a simple electromagnetic emission detection system. For example, the electromagnetic emissions of the engine and electronic systems of the vehicle may be attenuated by the body of the vehicle. Further, in reality, higher-order multi-pole fields are produced by the vehicle which may not truly radiate and may fall off sharply with increasing distance from the vehicle, thereby comprising a short-range field. In addition, in practical applications, the vehicle being targeted is typically in motion such that the field sensor is separate from the vehicle. This separation between vehicle and target introduces limitation factors such as the detection resolution of the field sensor, the treatment of the harmonics of the field produced by the vehicle, and signal noise from environmental conditions such as a local power grid or lightning. The actual operating state of the vehicle may also play a role in adding to the complexity of the analysis. For example, deteriorated electrical systems, peripheral systems such as air conditioning or anti-lock braking/traction control systems, or accessories such as a horn, stereo, navigation equipment, radar, or weapon systems may produce electromagnetic emissions which are detected by the field sensor along with the emissions of the main electrical operating system.

Also, in practical applications, specifically tactical situations, the field sensor must typically be separated from the analyzing unit used for receiving and processing the collected electromagnetic emission signal from the vehicle. The use of a separate field sensor considers equipment deployment issues and facilitates covert and/or remote identification of the targeted vehicle. In such instances, a wireline connection between the field sensor and the analyzing unit may not be practical. However, if a wireless system is considered, various other factors are introduced which may limit the applicability in practical situations. For example, the field sensor may include a transmitter engaged therewith, wherein both units need to be powered by a suitable power source and the package must be reasonably compact and unobtrusive. Further, the detected signal may be low in magnitude and may include extraneous noise. Thus, such a signal may require filtering and amplification to provide useful information. The detected emission data must then be transmitted to the analyzing unit. This data transmission also introduces other factors which must be considered, such as the signal-to-noise ratio and transmission rate of the transmitter/receiver, as well as the interceptability/security of the transmitted data. Further, in light of the multiple factors which must be considered in practically implementing a system for identification based on electromagnetic emission, the analysis of a large amount of collected data may be required in order to provide an effective identification tool.

Thus, there exists a need for an apparatus capable of identifying an electromagnetic emission source based upon the characteristics of the electromagnetic emission. Such an apparatus should be capable of detecting the electromagnetic emission of the source from a distance in an accurate and reliable manner. The apparatus should further be capable of collecting emission data having a sufficient signal-to-noise ratio to allow effective processing and analysis of the emission data for producing high resolution identification results. To expand the applicability of such an apparatus, it would also be advantageous for a detector portion thereof to be separable from the analysis portion so as to allow remote monitoring and analysis of detected emission data. Accordingly, the detector portion should be capable of transmitting the emission data to the analysis portion in a secure manner without significant signal loss or introduction of extraneous noise. In some instances, it would be advantageous for the apparatus to be capable of identifying the source of the electromagnetic emission as well as providing other useful information for facilitating identification of other characteristics of the source, such as the operating state of the source or the presence of other equipment or accessories on or about the source.

The above and other needs are met by the present invention which, in one embodiment, provides an electromagnetic emission source identification apparatus comprising a sensor device, a data transmitter, and a computer device. The sensor device is configured to sense an electromagnetic emission from a source, wherein the electromagnetic emission is sensed by the sensor device as corresponding sensed emission data. The data transmitter is in communication with the sensor device and is configured to transmit the sensed emission data from the sensor device. The computer device is configured to be in communication with the data transmitter. The computer device is further configured to process digital emission data, the digital emission data corresponding to the sensed emission data, so as to determine an identification indicator, an operational characteristic indicator, and/or an accessory characteristic indicator corresponding to the source.

Another advantageous aspect of the present invention comprises a computer device configured to implement an electromagnetic emission source identification apparatus for identifying a source from sensed emission data obtained from a sensor device. The sensed emission data is associated with an electromagnetic emission from the source. The sensor device is communicable with the computer device via a data transmitter. The computer device thus comprises a first processing portion configured to receive the sensed emission data. A second processing portion of the computer device is configured to then process digital emission data, the digital emission data corresponding to the sensed emission data, so as to determine an identification indicator, an operational characteristic indicator, and/or an accessory characteristic indicator corresponding to the source.

Still another advantageous aspect of the present invention comprises a method of identifying a source from an electromagnetic emission thereof, wherein the electromagnetic emission is convertible into corresponding sensed emission data. The sensed emission data is first received. Thereafter, digital emission data, corresponding to the sensed emission data, is processed with the computer device so as to determine an identification indicator, an operational characteristic indicator, and/or an accessory characteristic indicator corresponding to the source.

Yet still another advantageous aspect of the present invention comprises a method of processing digital emission data, the digital emission data corresponding to an electromagnetic emission of a source, so as to identify the source. First, the digital emission data is processed with a computer device so as to identify an identification indicator, an operational characteristic indicator, and/or an accessory characteristic indicator corresponding to the source. The characteristic marker of the source is then compared with a characteristic marker of each of a plurality of known sources in a database operably engaged with the computer device. The characteristic marker of each of the plurality of known sources corresponds to an identification indicator, an operational characteristic indicator, and/or an accessory characteristic indicator for the respective known source. The comparison between the characteristic marker of the source and the characteristic marker of each of the plurality of known sources is performed within a common reference frame. A best-match known source in the plurality of known sources corresponding to the source is thereby determined.

Another advantageous aspect of the present invention comprises a computer software program product, executable by a computer device, for identifying a source from an electromagnetic emission thereof, wherein the electromagnetic emission is convertible into corresponding sensed emission data. The computer software program product comprises a first executable portion for directing the collection of the sensed emission data. A second executable portion then processes digital emission data, the digital emission data corresponding to the sensed emission data, so as to determine an identification indicator, an operational characteristic indicator, and/or an accessory characteristic indicator corresponding to the source.

According to aspects of the present invention where an identification indicator, an operational characteristic indicator, and/or an accessory characteristic indicator corresponding to the source is determined, such results may then be compared to each of a plurality of known sources in a database operably engaged with the computer device, wherein each of the plurality of known sources in the database has associated therewith a corresponding identification indicator, operational characteristic indicator, and/or accessory characteristic indicator. The comparison between the source and each of the plurality of known sources is performed within a common reference frame. A best-match known source in the plurality of known sources corresponding to the source is thereby determined.

Thus, embodiments of the present invention provide an apparatus, associated methods, a computer device, and a computer software program product capable of identifying a source of electromagnetic emission based upon the characteristics of the electromagnetic emission. Such an apparatus is capable of detecting the electromagnetic emission of the source from a distance in an accurate and reliable manner. The apparatus is further capable of collecting emission data having a sufficient signal-to-noise ratio to allow effective processing and analysis of the emission data for producing high resolution identification results. Embodiments of such an apparatus further advantageously allow a detector portion to be separable from an analysis portion so as to allow remote monitoring and analysis of detected emission data. Accordingly, the detector portion is capable of transmitting the emission data to the analysis portion in a secure manner without significant signal loss or introduction of extraneous noise. In some instances, embodiments of the apparatus are capable of identifying the source of the electromagnetic emission as well as providing other useful information for facilitating identification of other characteristics of the source, such as the operating state of the source or the presence of other equipment or accessories on or about the source. Thus, embodiments of the present invention provide significant advantages as detailed herein.

Having thus described the invention in general terms, reference will now be made to the accompanying drawings, which are not necessarily drawn to scale relate to an example of the invention, and wherein:
**FIG. 1** is a schematic representation of an electromagnetic emission source identification apparatus according to one embodiment of the present invention.
**FIG. 2** is a schematic representation of a sensor device according to one embodiment of the present invention wherein the sensor device includes a data converter and a data transmitter.
**FIG. 3** is a schematic representation of an electromagnetic emission source identification apparatus according to the present invention showing a detection and identification situation, wherein the electromagnetic emission source comprises a vehicle.
**FIG. 4** is a schematic representation of an electromagnetic emission source identification apparatus according to another embodiment of the present invention, wherein a plurality of sensor devices are applied so as to provide identification, operating state, and/or accessory state information with respect to the source.
**FIG. 5** is a flowchart of a method of identifying an electromagnetic emission source according to one embodiment of the present invention.

The present invention now will be described more fully hereinafter with reference to the accompanying drawings, in which preferred embodiments of the invention are shown. This invention may, however, be embodied in many different forms and should not be construed as limited to the embodiments set forth herein; rather, these embodiments are provided so that this disclosure will be thorough and complete, and will fully convey the scope of the invention to those skilled in the art. Like numbers refer to like elements throughout.

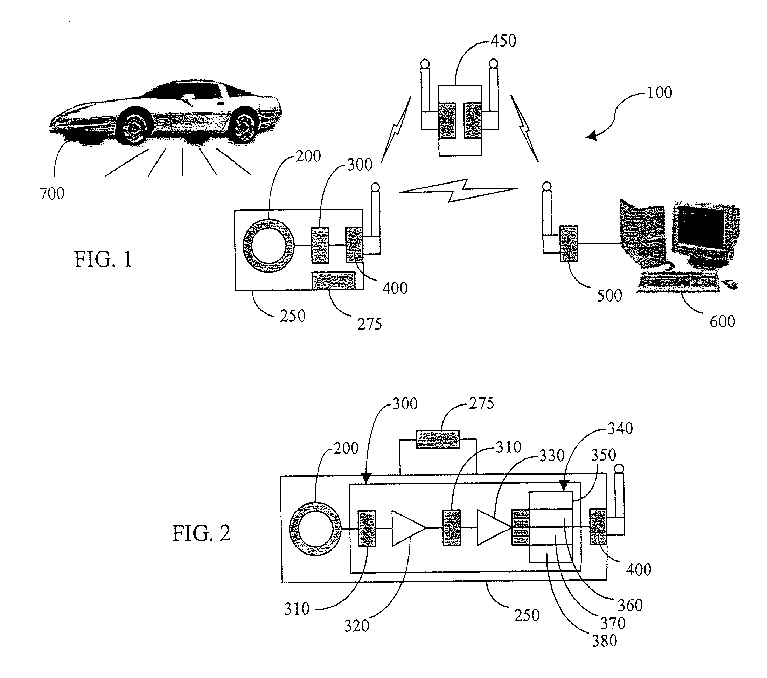

**FIG. 1** schematically illustrates an electromagnetic emission source identification apparatus, generally indicated by the numeral **100,** capable of identifying a source **700** of electromagnetic emission, from the characteristics of the electromagnetic emission, according to one embodiment of the present invention. The apparatus **100** generally comprises a sensor device **200,** a data converter **300,** a data transmitter **400,** a receiver **500**, and a computer device **600.** The sensor device **200** is operably engaged with the data transmitter **400** for detecting the electromagnetic emission of the source **700** as corresponding sensed emission data and then transmitting the sensed emission data to the receiver **500.** The receiver **500** is operably engaged with the computer device **600,** wherein the sensed emission data is received by the computer device **600** and processed to facilitate the identification of the source **700.** The sensed emission data may, in some instances, be converted to digital emission data prior to being received by the receiver **500** or, in other instances, after the sensed emission data has been received by the computer device **600.**

As previously described herein, a typical electromagnetic emission source ("EM source") **700** may comprise, for example, a passenger or tactical vehicle, wherein electrical current flow from the operation of ignition, charging, and other systems produces magnetic fields. These magnetic fields are detectable by a sensor device **200** comprising, for example, a wound wire coil. In such an instance, the EM field of the source **700** is detected by the coil **200** as a voltage. Several factors may determine the maximum usable range of the coil **200** as a sensor device such as, for instance, the magnitude of the voltage induced by the EM field and the thermal noise voltage on the coils. Generally, a high magnitude voltage signal/noise ratio may be detected by a coil **200** having relatively large diameter loops for the same total length of wire and more turns in the coil **200.** In addition, a stronger signal is generally attained at a higher frequency and/or magnetic field strength. Accordingly, coils of this type may be constructed as, for example, a generally planar loop or a loop having a cylindrical ferrite or other metallic core, with each different configuration having a different directional sensing pattern. In some instances, the coil **200** may incorporate appropriate shielding, such as electrostatic shielding, to reduce the sensitivity to various stray electrical fields. Thus, it will be understood that construction of such a field sensing coil **200** having the desirable properties as described herein will be appreciated by one skilled in the art and will not be addressed further herein.

It has been found, however, that various factors may affect the signal/noise ratio and/or sensitivity of the coil **200.** For example, in an instance where the coil **200** comprises a planar loop having a coil axis extending through the loop, the orientation of the axis in a substantially vertical direction reduces the sensitivity of the coil to substantially vertical lightning strikes. Still further, where the coil axis is substantially horizontally disposed, the coil **200** is less sensitive to substantially horizontal lightning strikes. Also, the EM field may, in some cases, be attenuated by the body of the vehicle. In such instances, usable signals are detectable in the very low frequency spectrum, usually up to about 10 kHz, but generally through the VLF spectrum up to about 50kHz. With this limitation, the applicable components of the apparatus **100** are appropriately configured.

Note that other configurations of a sensor device **200** are also anticipated according to other embodiments of the present invention. For example, the sensor device **200** may also comprise an RF antenna having an associated RF-indicating device, wherein such an RF device is capable of indicating, for example, detected power over either a large detection bandwidth, a narrow bandwidth, or a time-varying center frequency with a narrow bandwidth. An RF emission is typically a high frequency emission having a frequency range, for example, in the hundreds of MHz. However, in some instances, collected RF emission data may be processed to provide useful information in the VLF range. For instance, a power versus time analysis in the RF range, when transformed to a frequency domain, may provide useful VLF range information. Thus, it will be understood and appreciated by one skilled in the art that many different configurations of a sensor device **200** are contemplated within the scope of the present invention. In addition, it will be understood that, where a different frequency analysis range is contemplated for the sensor device **200,** that other components and capabilities thereof as described herein may be modified, replaced, or otherwise adapted to meet the detection, data transmission, and analysis of that frequency range according to the present invention.

In instances where a remote wireless sensor device **200** is desired, the sensor device **200** may be incorporated with other necessary components in a sensor module **250.** Accordingly, **FIG. 1** and, in further detail, **FIG. 2** schematically illustrate one embodiment of a sensor module **250** according to the present invention. The sensor module **250** generally comprises the sensor device **200,** the data converter **300,** and the data transmitter **400.** The sensor module **250** may further include a power source **275** operably engaged therewith for powering the components therein. As shown in **FIG. 2,** the data converter **300** may include, for example, one or more filters **310,** one or more amplifiers **320,** an analog to digital converter ("ADC") **330,** and a processor **340,** wherein the processor **340** may further comprise a compression module **350,** an encoding/encryption module **360,** a trigger module **370,** and a buffer module **380.**

Upon reception of the VLF emission data of a source through the sensor device **200,** the signal may be filtered by the various filters **310** so as to attenuate and/or remove out-of-band signals due to, for example, spurious AC power signals and then amplified by one or more amplifiers **320** to enhance the signals of interest. Preferably, low noise, wide dynamic range, and/or high common mode rejection amplifiers **320** are implemented. In some instances, the sensor module **250** includes an ADC **330** for converting the collected analog emission data to digital emission data prior to transmission of the emission data to the computer device **600**. In such instances, the ADC **330** may be configured so as to, for example, digitize the analog emission data with between about 16 to about 22 bits at about 22 kHz or 44 kHz though, depending on the actual requirements of the application, the configuration of the ADC **330** may vary. It will be appreciated by one skilled in the art, however, that, in other instances, the emission data may be transmitted to the computer device **600** in analog form and then converted to digital form within the computer device **600** prior to or commensurately with processing of the data. Still further, implementation of a system whereby analog data is converted to digital data will be understood and appreciated by one skilled in the art and will not be further discussed herein.

According to embodiments of the present invention, wherein the sensor module **250** includes an ADC **330,** once the digital emission data has been formed from the converted analog emission data, one or more processing steps may be performed by the processor **340** prior to the digital emission data being transmitted to the computer device **600.** For example, the digital emission data may be compressed by the compression module **350** so as to conserve bandwidth and reduce the data transmission time. In other instances, the digital emission data may be encoded or encrypted by the encoding/encryption module **360** for security reasons prior to transmission. Accordingly, the digital emission data may be transformed by the encoding/encryption module **360** to be consistent with, for example, a frequency division multiple access ("FDMA") transmission scheme, a spread spectrum transmission scheme, or a phase, frequency, or amplitude modulation transmission scheme. Further, the transmitted digital emission data may be encoded by phasing the data using coherent clocks at both the transmitting and receiving ends of the communication. In addition, hierarchical channels may be used to separate and designate classes of data or differentiate sensor events. It will be understood by one skilled in the art, however, that many different methods and techniques may be employed within the spirit and scope of the present invention to accomplish effective and efficient transmission of the digital emission data in a secure manner between the sensor module **250** and the computer device **600** via the data transmitter **400** and the receiver **500.**

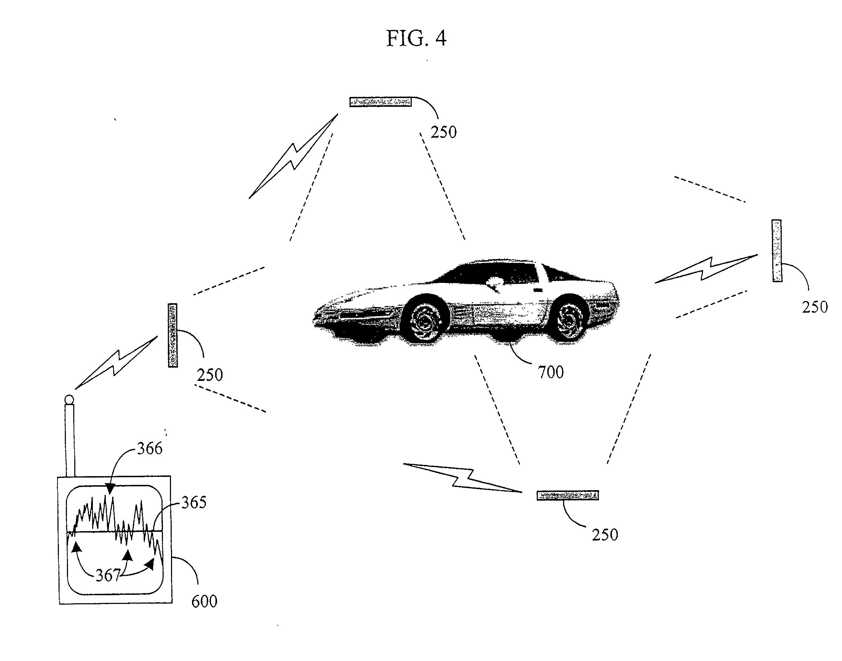

Further, various techniques may be implemented to limit the transmission or processing of non-useful emission data. For example, in some instances, a threshold signal intensity **365** corresponding to the digital emission data may be designated whereby the super-threshold digital emission data **366** may comprise the portion of the data desired for further analysis. This relationship is schematically shown, for example, in **FIG. 4.** Accordingly, the designated threshold signal intensity **365** may be used to configure the trigger module **370** to be responsive to detected digital emission data meeting or exceeding the threshold signal intensity **365.** Generally, activation of the trigger module **370** may result in the initiation the transmission of super-threshold digital emission data **366** to the computer device **600** via the data transmitter **400.** However, the buffer module **380** comprising, for example, a ring buffer, may be configured such that at least a portion of, if not all, the digital emission data is routed therethrough. When the detection of super-threshold digital emission data **366** activates the trigger module **370,** the buffer module **380** may also be activated so as to capture a portion of the sub-threshold digital emission data **367** preceding the threshold signal intensity **365.** The captured portion of the sub-threshold digital emission data **367** may then be included with the super-threshold digital emission data **366** transmitted to the computer device **600** so as to reasonably expand the amount of collected data to present a more detailed record surrounding the detected event. Note that the recession of the detected digital emission data to below the threshold signal intensity **365** will stop the transmission of super-threshold digital emission data **366.** However, the buffer module **380** may also capture a portion of the sub-threshold digital emission data **367** following the recession of the detected digital emission data below the threshold signal intensity **365,** wherein a portion of the sub-threshold digital emission data **367** of this portion of the record is also transmitted to the computer device **600.** Thus, the record of the detected event is essentially expanded about the initiation and cessation thereof as indicated by the threshold signal intensity **365.**

In some instances, conservation of the available power from the power source **275** may be advantageous for increasing the efficiency of the apparatus **100.** Accordingly, many different techniques may be applied in order to extend the effective service time of the power source **275.** For example, the sensor module **250** may be configured to "sleep" or otherwise become inactive for a predetermined period. Upon expiration of that period, the sensor module **250** is activated to sample the environment for electromagnetic emissions above the level of a previously determined background. If the sensor module **250** detects a change, the sensor module **250** is activated so as to collect the desired emission data. If no change from the background is detected, the sensor module **250** reenters the sleep mode. It will be understood and appreciated by one skilled in the art, however, the many different power conservation approaches may be implemented so as to be effective with respect to the described apparatus **100** within the spirit and scope of the present invention.

As shown in **FIGS. 1 and 2,** once the emission data has been detected and converted to digital emission data, the digital emission data may be manipulated in various manners prior to being transmitted to the computer device **600.** Transmission of the digital emission data is accomplished via a data transmitter **400** communicating with a corresponding receiver **500** operably engaging the computer device **600.** Preferably, communication between the data transmitter **400** and the receiver **500** is accomplished over a wireless link so as to, for example, maximize the flexibility of the configuration of the apparatus **100** and allow for small and unobtrusive packaging for the sensor module **250.** For instance, a wireless sensor module **250** may be configured to fit in a small diameter pipe, to be installed under a manhole cover, or to be hung on a dock piling or storm drain grate, though many different configurations and deployment situations may be considered within the scope of the present invention.

In addition, in some instances, the apparatus **100** may further advantageously comprise a repeater unit **450** disposed between the sensor module **250** and the receiver **500** as will be appreciated by one skilled in the art. Such a repeater unit **450** may have, with the exception of the sensor device **200,** any or all of the components and/or functionality of the sensor module **250.** By providing a separate repeater unit **450,** the sensor device **200** and/or sensor module **250** may advantageously be smaller and less obtrusive, while providing greater flexibility for packaging thereof. In addition, since the use of a repeater unit **450** may allow power-consuming components to be removed from the sensor module **250,** and thus promote power conservation so as to extend deployability thereof. In some instances, data computation may also be facilitated where, for example, preliminary processing of the emission data may be accomplished by the repeater unit **450.** Where a repeater unit **450** is incorporated into the apparatus **100,** and a wireless communication scheme is employed, the sensor module **250** may communicate with the repeater unit **450** via a first frequency in, for example, the VHF frequency range. The repeater unit **450,** in such an instance, is further configured to communicate with the receiver **500** via a second frequency, different from the first frequency, also in, for example, the VHF frequency range. In either instance, namely where communication between the data transmitter **400** and the receiver **500** occurs with or without the presence of a repeater unit therebetween, it will also be appreciated and understood by one skilled in the art that it may be advantageous for the computer device **600,** receiver **500,** or other component associated therewith to also be capable of transmitting information such as, for example, commands, to the repeater unit **450** and/or the sensor module **250** or to the sensor module **250** via the repeater unit **450.** In such instances, the data transmitter **400,** the receiver **500,** and/or the repeater unit **450** may comprise, for example, a transceiver, though the same functionality may also be accomplished by the addition of appropriate components to the existing apparatus **100.** Note that it may also be advantageous for communication between the data transmitter **400** and the receiver **500** to be accomplished via a wireline connection, wherein the apparatus **100** may be accordingly configured for such a situation as will be understood and appreciated by one skilled in the art. Embodiments of the apparatus **100** as described herein are generally configured to operate within the VLF spectrum. However, the data transmitter **400** and receiver **500** do not necessarily operate within the same frequency range. Accordingly, in one embodiment, the wireless data transmitter **400**/receiver **500** operates at a frequency, also known as the carrier or center frequency, of between, for example, about 3 MHz and about 3 GHz, with a particularly useful range of between about 100 MHz and 1 GHz. Such a wireless data transmitter **400**/receiver **500** may support, for example, modulation of between about 20 Hz and 20 kHz, with a dynamic range of about 120 dB.

A consideration addressed by the present invention is the detected electromagnetic emission from local power grids, which are typically realized at a frequency of about 60 Hz (or about 50 Hz in, for example, European countries). However, the local power grid frequency is often not exactly centered at 50 Hz or 60 Hz and may include harmonics thereof well past, for example, the 100^{th} harmonic at about 6 kHz for a 60 Hz power grid. In such instances, embodiments of the present invention do not attenuate the signal due to the local power grid, though attenuation of this signal may certainly be contemplated and implemented if required by the particular application. Generally, the static presence of the local power grid signal component is measured both before and after a detectable event such as, for example, a source **700** passing by the sensor module **250.** The local power grid signal component is then subtracted from the entire detected signal such that the resultant signal is substantially correlated with the electromagnetic emission of the source **700.** In other instances, the local power grid signal component may be used as, for example, a test signal indicative of a baseline signal. If, for instance, a portion of the local power grid signal component is detected that is out of phase with the remainder of the local power grid signal component, the presence of that out-of-phase portion may be indicative of the presence of a non-emissive object in the monitored area.

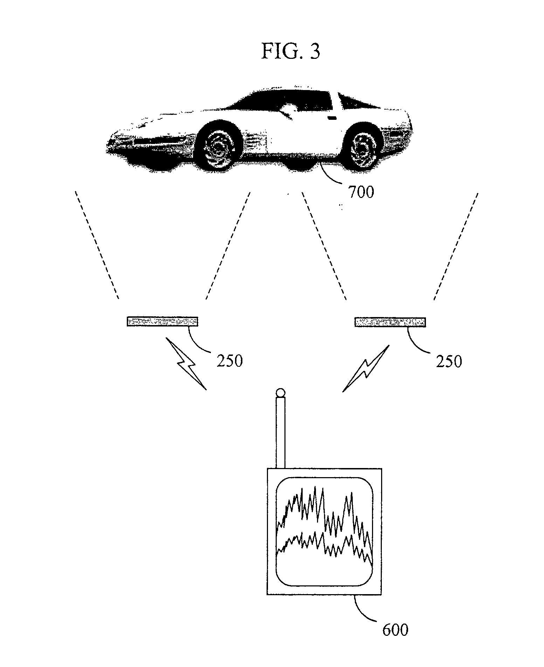

Once the digital emission data is received by the computer device **600** via the receiver **500,** the wealth of information must be processed so as to provide useful and applicable results. The amount of collected information may be increased markedly by the use of more than one sensor device **200.** Where a plurality of sensor devices **200** are implemented, each sensor device **200** may be part of an individual sensor module **250** or each sensor device **200** may share one or more components with another sensor device **200.** For example, one or more sensor devices **200** may be connected to a single power source **275,** data converter **300,** and data transmitter **400.** In other instances, only a data transmitter **400** may be shared, wherein each sensor device **200** has its own power source **275** and data converter **300.** It will be understood and appreciated by one skilled in the art, however, the various amount of sensor devices **200** and components operable therewith may be employed in various combinations or configurations depending on the requirements of the particular application and the specific information being sought. For example, as shown in **FIGS. 3 and 4,** multiple sensor devices **200** with varying orientations may be deployed, with each sensor device **200** being tuned to achieve a different sensitivity level or other parameter. In such a manner, the velocity of the source vehicle **700** may be accurately determined, but also, for example, the direction in which the vehicle **700** is headed as well as any events which may occur at a certain point. For instance, the vehicle **700** (or personnel therein) may activate a weapon system when approaching within a certain range of a target detected by the vehicle's radar, wherein the activation of the weapon system is detectable by a sensor device **200.** If the target is detected, as indicated by the sensing of the weapon system activation, the target will have some warning in which to activate defenses. However, if the target is not detected, the defenses need not be unnecessarily activated. In other instances, multiple sensor devices **200** may provide information redundancy for verification purposes so as to confirm the results of an analysis or to filter out instantaneous signals according to a time domain analysis, such an instantaneous signal corresponding to, for example, a lightning strike. In still other instances, the implementation of multiple sensors **200** may provide a back-up or alternate component in the event of the failure of another sensor device **200.**

The computer device **600** thereby comprises a powerful and important analysis tool for the collected emission data. The computer device **600** may thus be configured to process the emission data in accordance with the desired result using an analysis scheme suited for handling large amounts of data such as, for instance, artificial neural networks. In addition, for example, the emission data may be reduced to a practical and applicable form when processed according to one or more of an autocorrelation analysis, a short time Fourier transformation ("STFT") analysis, a joint time-frequency analysis ("JTFA"), an rms power versus time in a frequency band analysis, a static frequency analysis, a harmonics analysis, an acoustical analysis, an analysis of a short time duration record (comprising, for example, a bipolar signal versus time in a frequency window analysis or a power versus frequency in a time window analysis), an adaptive noise cancellation analysis, an adaptive frequency domain recognition analysis, or combinations thereof. It will be understood and appreciated by one skilled in the art, however, the collected data may be analyzed in many different manners and according to many different techniques other than those mentioned herein depending on the resulting information desired, but will generally be indicated by an intensity value with respect to a reference domain such as, for instance, a power intensity measurement with respect to a time domain. For example, the emission data from multiple sensor devices **200** may be processed into a correlation between rms power versus time in a frequency band. In such an analysis, the differences in the trends of the emission data from the sensor devices **200** in known relation to each other may indicate, for example, the velocity and direction of the vehicle **700** or the point at which an accessory thereof is activated. Other correlations of multiple sensor device **200** emission data may also be applied such as, for example, correlating data peaks in a time domain to determine similar resulting information or to provide redundancy or confirmation of other analyses. In some cases, the electromagnetic emission of a vehicle **700** may be affected by the body of the vehicle or other components such that the vehicle **700** may have certain resonances, wherein the orientation, motion, or other characteristics of the vehicle **700** with respect to the sensor device **200** may be determined from the resonance characteristics of the detected electromagnetic emission. Still further, for example, when analyzing the emission data corresponding to an event detected by a sensor device **200,** the analysis of the rate of increase of the signal power, the effective signal plateau length, and the rate of decrease of the signal power of the event maybe used to determine the speed and distance of the source **700** relative to the sensor device **200.**

Accordingly, the processed emission data may indicate, as described herein, characteristics which serve to identify the emission source **700.** Such an identification indicator may comprise, for example, a peak in an rms power versus time relationship that is produced by a specific vehicle **700.** In other instances, multiple sensors may produce multiple relationships which may be used to identify an operational state of the vehicle **700.** For example, as previously described, the data may be analyzed or correlated so as to produce an operational characteristic indicator such as velocity, direction, or operating condition of the vehicle **700.** Further, the vehicle **700** may have characteristics which may be separated into time dependent events such as, for example, the firing of the spark plugs while the engine is operating, and time independent events such as, for example, the operation of accessories in the vehicle including, for example, the air conditioning system, the stereo system, an anti-lock braking, or a traction control system. Such accessory characteristic indicators may be determined from, for example, an rms power versus time in a frequency band analysis or an STFT analysis and may be indicative of the operating mode, condition, or other decipherable parameter which may important to consider.

In order to identify the source **700,** the processed emission data is compared to other data, contained in a database internal or external to the computer device **600,** corresponding to a plurality of known sources. It will be understood that comparisons between data for the source **700** and the known sources within the database occurs with common parameters such as, for example, where both the source **700** and the known sources are compared across a similar frequency domain and range. In addition, the database may comprise data for known sources similar to the detected source **700** or may comprise multiple related and unrelated classes of known sources. For example, if the sensor device **200** is configured and deployed to detect enemy vehicles, the database may comprise processed emission data on one or more known enemy vehicles. However, where the target is nonspecific, the database may contain processed emission data for, for example, enemy military vehicles, civilian vehicles, the local power grid, local buildings, or other sources of electromagnetic emission within the vicinity of the target.

In addition, though the data within the database may be continuous such as, for example, having the operational characteristics of an engine across a wide rpm range, the data may also be discrete such as, for example, the engine at idle, at a mid-range rpm and at red line rpm. Where access to a known source is limited, the data thereof within the database may comprise one or more very limited events. Accordingly, in instances where the data is continuous, correlation of the source data to the known source data within the database is a matter of determining the best-fit or highest correlation match therebetween. In other instances, where the database contains discrete or limited data corresponding to the known source, correlation with the source data may require, for example, different forms of correlation, interpolation, or extrapolation in order to identify a highest correlation known source. Further, the appropriate comparison between the source **700** and the known sources, while occurring within a common reference frame, may be accomplished through the use of characteristic markers exhibited by the source **700.** For example, the source **700** may have characteristic intensity peaks at specific frequencies. The database may be thereafter interrogated to produce one or more corresponding known source profiles indicating close matches to the characteristic marker peaks of the source **700,** wherein a highest correlation known source is thereafter determined. The highest correlation known source may be determined through, for example, the analysis of characteristic markers of the source according to a plurality of analysis techniques, wherein the database is accessed for the characteristic markers of the known sources analyzed according to the same plurality of analysis techniques. The matches are then compared across different techniques for redundancy or verification of the resulting best-match identification.

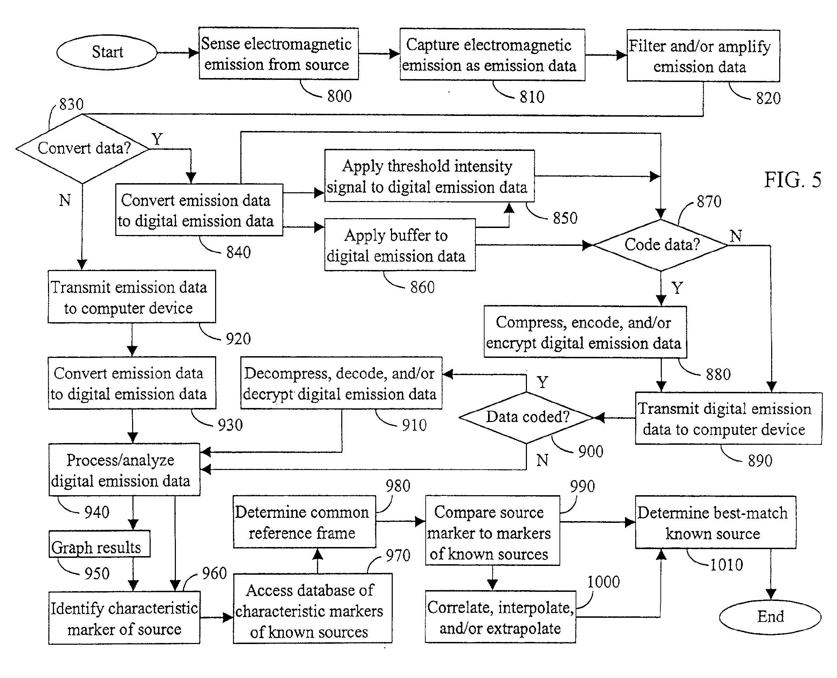

**FIG. 5** illustrates a flowchart corresponding to a general method as more particularly described herein. Once the electromagnetic emission from the source **700** is detected (**Block 800**) by the sensor device **200,** the electromagnetic emission is captured as emission data (**Block 810**). If the sensor module includes a data converter **300**, the emission data may then be filtered by one or more filters **310** and/or amplified by one or more amplifiers **320** (**Block 820**). In some instances, the emission data may be converted to digital emission data (**Block 830**) prior to transmission of the digital emission data by the data transmitter **400.** Where the sensor module **250** includes an ADC **330,** the emission data is converted to digital emission data (**Block 840**). Thereafter, the digital emission data may be processed by a processor **340** in different manners such as, for example, by having a threshold signal intensity **365** applied to the digital emission data with a trigger module **370** (**Block 850**) and/or by being directed through a buffer module **380** (**Block 860**). Further, the digital emission data may be coded (**Block 870**) by the compression module **350** and/or the encoding/encryption module **360** so as to compress, encode, and/or encrypt (**Block 880**) the digital emission data prior to transmission thereof to the computer device **600** (**Block 890**). In some instances, however, the digital emission data may be transmitted to the computer device **600** (**Block 890**), via the data transmitter **400** and the receiver **500,** without being coded. If the digital emission data was coded prior to transmission (**Block 900**), the digital emission data is the decompressed, decoded, and/or decrypted (**Block 910**) after being received by the receiver **500** and/or the computer device **600.** In instances where the emission data is not converted to digital emission data (**Block 830**) prior to transmission, the emission data is transmitted to the computer device (**Block 920**), via the data transmitter **400** and the receiver **500,** and then converted to digital emission data by the computer device **600** (**Block 930**).

Once the digital emission data is received by the computer device **600,** the digital emission data is processed or otherwise analyzed by the computer device **600** (**Block 940**), such as by applying STFT or JTFA thereto. The processed results may then be converted into a graphical representation (**Block 950**) and/or analyzed to identify a characteristic marker of the source **700** (**Block 960**). A database operably engaged with the computer device **600** is then accessed, wherein the database includes characteristic markers of known sources (**Block 970**). Upon determining a common reference frame (**Block 980**) between the characteristic marker of the source **700** and the characteristic markers of the known sources (**Block 980**), the characteristic marker of the source **700** is compared to the characteristic markers of the known sources (**Block 990**) so as to determine a best-match known source (**Block 1010**). Where necessary, the comparison may involve correlating, interpolating, and/or extrapolating (**Block 1000**) with respect to the characteristic markers of the known sources in the database before determining a best-match known source (**Block 1010**).

Thus, embodiments of the present invention provide an apparatus **100** (with associated methods, computer device, and computer software program product) capable of identifying a source of electromagnetic emission based upon the characteristics of the electromagnetic emission. Such an apparatus **100** is capable of detecting the electromagnetic emission of the source **700** from a distance in an accurate and reliable manner. The apparatus **100** is further capable of collecting emission data having a sufficient signal-to-noise ratio to allow effective processing and analysis of the emission data for producing high resolution identification results. Embodiments of such an apparatus **100** further advantageously allow a detector portion to be separable from an analysis portion so as to allow remote monitoring and analysis of detected emission data. Accordingly, the detector portion is capable of transmitting the emission data to the analysis portion in a secure manner without significant signal loss or introduction of extraneous noise. In some instances, embodiments of the apparatus **100** are capable of identifying the source **700** of the electromagnetic emission as well as providing other useful information for facilitating identification of other characteristics of the source, such as the operating state of the source **700** or the presence of other equipment or accessories on or about the source **700.** Accordingly, the apparatus **100** may have many different configurations and may be applied in a defensive or offensive manner as will be understood and appreciated by one skilled in the art as being consistent with the capabilities of the present invention.

Many modifications and other embodiments of the invention will come to mind to one skilled in the art to which this invention pertains having the benefit of the teachings presented in the foregoing descriptions and the associated drawings. For example, there may be many different configurations and applications of an apparatus **100** as described herein. Besides being used in tactical situations to identify vehicles, the apparatus **100** may be configured to detect and identify personnel carrying active electronics such as, for example, electrically operated watches, transmitters, or receivers. Such an apparatus **100** may also be used to monitor power grid or power lines fluctuations indicative of generator and/or load variations. The apparatus **100** may also be applied to many different situations such as, for instance, vehicle tracking, vehicle speed monitoring, traffic monitoring, the detection and identification of marine vessels and marine implaced hardware such as mines and buoys, the detection of multiple vehicles by using, for example, time of arrival techniques, or as a smart trigger for mines or munitions.

Still further, an apparatus **100** according to the present invention may be integrated into a robot so as to guide the robot and to facilitate tracking and targeting of a detected and identified vehicle or mine. Such a robotic system could be used in automated reconnaissance, surveillance, or as a trigger in an ordinance. In some instances, a VLF transmitter may be associated with the system, whereby the transmitter may be provided with, for example, a particular vehicle so as to tag or otherwise identify the vehicle to the detection system. In addition, embodiments of an apparatus **100** according to the present invention may be configured to determine, for example, the operating state of combustion engines, motors, electrical systems, and/or mechanical systems. In doing so, the apparatus **100** may provide real-time, non-invasive monitoring of the performance and/or load of the monitored component. Such information could indicate performance degradation or impending failure, thereby reducing down time, increasing efficiency, and identifying instances where maintenance or repair is necessary. More specifically, the apparatus **100** may be configured to monitor combustion engines to determine timing of fuel injections, spark, or cylinder-to-cylinder explosions or to monitor an array of motors or generators and communicating information such as loading, phase, or secondary characteristics of power generation via a wireless or wired link to a control unit that distributes power or load to the system. In addition, the apparatus **100** may be used to diagnose fluorescent tube failure or malfunction, monitor general atmospheric VLF noise and other emissions, monitor the function of electric actuators such as solenoids, breakers, transformers, or to monitor the operation of electrically or magnetically based deposition or control equipment, such as plasma deposition equipment.

In tactical situations, embodiments of an apparatus **100** according to other embodiments of the present invention may be used as offensive electronic countermeasures such as a decoy, a jammer, or an EM field signature reducer. In defensive situations, such an apparatus **100** could provide a vehicle drive-by alert system, discriminate smart mines, could monitor traffic centers on land or on water, or could be packaged and deployed in a clandestine manner to provide covert surveillance. In addition, such an apparatus **100** may be used to monitor power grids or other systems associated with command posts or monitor troop movement or weaponry status.

Therefore, it is to be understood that the invention is not to be limited to the specific embodiments disclosed and that modifications and other embodiments are intended to be included within the scope of the appended claims. Although specific terms are employed herein, they are used in a generic and descriptive sense only and not for purposes of limitation.

## Claims

1. An electromagnetic emission source (700) identification apparatus (100) comprising:
a sensor device (200) configured to sense an electromagnetic emission from a source (700), the electromagnetic emission being sensed by the sensor device (200) as corresponding sensed emission data;
a data transmitter (400) in communication with the sensor device (200) and configured to transmit the sensed emission data from the sensor device (200); and
a computer device (600) in communication with the data transmitter (400) and configured to process digital emission data, the digital emission data corresponding to the sensed emission data, so as to determine at least one of an identification indicator, an operational characteristic indicator, and an accessory characteristic indicator corresponding to the source (700).

2. An apparatus according to claim 1 wherein the sensor device (700) further comprises a wound wire coil defining an axis therethrough.

3. An apparatus according to claim 2 wherein the wound wire coil further comprises a ferrite core disposed along the axis.

4. An apparatus according to claim 2 or 3 wherein the axis is substantially vertically disposed such that the sensor device (200) is less sensitive to electromagnetic emission from a substantially vertical lightning strike.

5. An apparatus according to claim 2 or 3 wherein the axis is substantially horizontally disposed such that the sensor device (200) is less sensitive to electromagnetic emission from a substantially horizontal lightning strike.

6. An apparatus according to any preceding claim further comprising an electrostatic shielding apparatus operably engaged with the sensor device (200).

7. An apparatus according to any preceding claim wherein the data transmitter (400) comprises a wireless transmitter.

8. An apparatus according to claim 7 wherein the data transmitter comprises a wireless transmitter operating within a frequency range of between about 3 MHz and about 3GHz.

9. An apparatus according to claim 7 or 8 wherein the data transmitter comprises a wireless transmitter having a modulation of between about 20 Hz and about 20 kHz with a dynamic range of at least about 80 dB.

10. An apparatus according to any preceding claim further comprising a data converter module (300) in communication with at least one of the sensor device (200), the data transmitter (400) and the computer device (600), the data converter module being configured to convert (840, 930) the sensed emission data into corresponding digital emission data.

11. An apparatus according to claim 10 wherein the data converter module (300) is further configured to convert (840, 930) the sensed emission data into corresponding digital emission data without attenuating a local power grid emission component.

12. An apparatus according to claim 10 wherein the data converter module (300) is further configured to at least one of filter (820) the sensed emission data and amplify (820) the sensed emission data prior to converting (840, 930) the sensed emission data to digital emission data.

13. An apparatus according to claim 10, 11 or 12 wherein the digital emission data further comprises a threshold signal intensity (365) separating sub-threshold digital emission data (367) from super-threshold digital emission data (366).

14. An apparatus according to claim 10, 11 or 12 further comprising a processing module (340) in communication with the data converter module (300) and configured to receive and process the digital emission data.

15. An apparatus according to claim 10, 11 or 12 further comprising a processing module (340) having a trigger module (370) responsive to a threshold signal intensity (365), the threshold signal intensity (365) separating sub-threshold digital emission data (367) from super-threshold digital emission data (366), to actuate transmission of the super-threshold digital emission data by the data transmitter (400).

16. An apparatus according to claim 10, 11, 12, 14 or 15 further comprising a processing module (340) having a buffer module (380) configured to retain (860) at least a portion of the digital emission data, the buffer module (380) being responsive to a threshold signal intensity (365), the threshold signal intensity (365) separating sub-threshold digital emission data (367) from super-threshold digital emission data (366), to actuate transmission of the at least a portion of the sub-threshold digital emission data (367) with the super-threshold digital emission data (366) by the data transmitter (400).

17. An apparatus according to claim 14, 15 or 16 wherein the processing module (340) further comprises a compression module (350) configured to compress (880) the digital emission data.

18. An apparatus according to any one of claims 14 to 17 wherein the processing module (340) further comprises a coding module (360) configured to at least one of encode (880) and encrypt (880) the digital emission data.

19. An apparatus according to any one of claims 14 to 18 wherein the processing module (340) operably engages the data transmitter (400) such that the data transmitter (400) transmits (890) the digital emission data to the computer device (600).

20. An apparatus according to any one of claims 10 to 14 wherein the processing module operably engages the computer device (600) such that the sensed emission data is converted (930) into the corresponding digital emission data after the sensed emission data is transmitted to the computer device (600) from the data transmitter (400).

21. An apparatus according to any preceding claim wherein the computer device (600) is further configured to process (940) the digital emission data according to at least one of a power versus time in a frequency band analysis, a static frequency analysis, a joint time-frequency analysis (JTFA), an acoustic analysis, a short time duration analysis, and a short time Fourier transform (STFT) analysis so as to determine at least one of the identification indicator, the operational characteristic indicator, and the accessory characteristic indicator corresponding to the source (700).

22. An apparatus according to any preceding claim further comprising a plurality of sensor devices (250) in communication with the computer device (600), wherein the computer device (600) is configured to process the digital emission data from the plurality of sensor devices (250).

23. An apparatus according to claim 22 wherein the computer device (600) is configured to process the digital emission data from the plurality of sensor devices according to a power versus time in a frequency band analysis so as to determine at least one of the operational characteristic indicator and the accessory characteristic indicator corresponding to the source (700).

24. An apparatus according to claim 22 wherein the computer device is configured to process (940) the digital emission data from the plurality of sensor devices (250) according to at least one of a short time duration analysis and a short time Fourier transform (STET) analysis so as to determine (960) the accessory characteristic indicator corresponding to the source.

25. An apparatus according to claim 1 further comprising a database operably engaged (970) with the computer device (600) and configured so as to have accessible therein at least one of an identification indicator, an operational characteristic indicator, and an accessory characteristic indicator corresponding to each of a plurality of known sources.

26. An apparatus according to claim 25 wherein the computer device (600) is further configured to compare (990) at least one of the identification indicator, the operational characteristic indicator, and the accessory characteristic indicator corresponding to the source (700) with the corresponding at least one of the identification indicator, the operational characteristic indicator, and the accessory characteristic indicator corresponding to each of the plurality of known sources in the database so as to identify (1000) a highest correlation known source of the plurality of known sources.

27. A computer device (600) configured to implement an electromagnetic emission source identification apparatus for identifying a source (700) from sensed emission data obtained from a sensor device (200), the sensed emission data being associated with an electromagnetic emission from the source (700), the sensor device (200) being communicable with the computer device (700) *via* a data transmitter (400) said computer device (700) comprising:
a first processing portion (500) configured to receive the sensed emission data; and
a second processing portion configured to process (940 ...) digital emission data, the digital emission data corresponding to the sensed emission data, so as to determine at least one of an identification indicator, an operational characteristic indicator, and an accessory characteristic indicator corresponding to the source (700).

28. A computer device according to claim 27 further comprising a processing portion configured to convert (930) the sensed emission data into corresponding digital emission data.

29. A computer device according to claim 27 or 28 wherein the second processing portion is further configured to process (940) the sensed emission data according to at least one of a power versus time in a frequency band analysis, a static frequency analysis, a joint time-frequency analysis (JTFA), an acoustic analysis, a short time duration analysis, and a short time Fourier transform (STFT) analysis so as to produce an intensity result with respect to a reference domain.

30. A computer device according to claim 27, 28 or 29 further comprising a processing portion (950) configured to provide a graphical representation of the intensity result with respect to the reference domain.

31. A computer device according to claim 29 further comprising a processing portion configured to identify (960) a characteristic marker from the intensity result with respect to the reference domain, the characteristic marker corresponding to at least one of the identification indicator, the operational characteristic indicator, and the accessory characteristic indicator of the source (700).

32. A computer device according to any one of claims 27 to 31 further comprising a database operably engaged (970) therewith and configured so as to have accessible therein a characteristic marker corresponding to at least one of an identification indicator, an operational characteristic indicator, and an accessory characteristic indicator for each of a plurality of known sources.

33. A computer device according to claim 32 further comprising a processing portion configured to determine (980) a common reference frame between a characteristic marker of the source and the corresponding characteristic marker of each of the plurality of known sources in the database using at least one of a correlation analysis, an interpolation analysis, and an extrapolation analysis.

34. A computer device according to claim 32 further comprising a processing portion configured to compare (990) a characteristic marker of the source with the corresponding characteristic marker of each of the plurality of known sources in the database within a common reference frame so as to determine (1010) a best-match known source in the plurality of known sources.

35. A computer device according to claim 32 further comprising a processing portion configured to perform (1010) a redundancy comparison between the source (700) and the plurality of known sources in the database so as to verify the best-match known source.

36. A computer device according to claim 32 further comprising a processing portion configured to compare (990) at least one of the identification indicator, the operational characteristic indicator, and the accessory characteristic indicator corresponding to the source with the corresponding at least one of the identification indicator, the operational characteristic indicator, and the accessory characteristic indicator corresponding to each of the plurality of known sources in the database so as to identify (1010) a best-match known source in the plurality of known sources.

37. A method of identifying a source (700) from an electromagnetic emission thereof, the electromagnetic emission being convertible into corresponding sensed emission data, said method comprising:
receiving (890, 920) the sensed emission data; and
processing (940) digital emission data, the digital emission data corresponding to the sensed emission data, with a computer device (600) so as to determine (960) at least one of an identification indicator, an operational characteristic indicator, and an accessory characteristic indicator corresponding to the source (700).

38. A method according to claim 37 further comprising detecting (800) the electromagnetic emission of the source (700) with a sensor device (200) prior to receiving (890, 920) the sensed emission data.

39. A method according to claim 27 or 38 wherein detecting (800) the electromagnetic emission further comprises detecting the electromagnetic emission of the source (700) with a wound wire coil (200) defining an axis therethrough.

40. A method according to claim 38 wherein detecting (800) the electromagnetic emission further comprises detecting the electromagnetic emission of the source (700) with a wound wire coil (200) defining an axis therethrough and further comprising a ferrite core disposed along the axis.

41. A method according to claim 38, 39 or 40 wherein detecting (800) the electromagnetic emission further comprises detecting the electromagnetic emission of the source (700) so as to lessen the sensitivity to electromagnetic emission from a substantially vertical lightning strike.

42. A method according to claim 38, 39 or 40 wherein detecting (800) the electromagnetic emission further comprises detecting the electromagnetic emission of the source (700) so as to lessen the sensitivity to electromagnetic emission from a substantially horizontal lightning strike.

43. A method according to claim 38 further comprising converting (820) the electromagnetic emission of the source (700) into sensed emission data after detecting (800) the electromagnetic emission of the source (700).

44. A method according to claim 38 further comprising transmitting (920) the electromagnetic emission to the computer device (600) as sensed emission data.

45. A method according to claim 37 further comprising converting (840, 930) the sensed emission data to digital emission data.

46. A method according to claim 45 further comprising filtering (820) the sensed emission data prior to converting (840, 930) the sensed emission data to digital emission data.

47. A method according to claim 45 or 46 further comprising amplifying (820) the sensed emission data prior to converting (840, 930) the sensed emission data to digital emission data.

48. A method according to claim 45, 46 or 47 further comprising transmitting (890) the digital emission data to the computer device (600) after converting (840) the sensed emission data to digital emission data.

49. A method according to claim 45, 46, 47 or 48 wherein converting (840, 930) the sensed emission data to digital emission data further comprises converting the sensed emission data to digital emission data without attenuating a local power grid emission component.

50. A method according to claim 45, 46 or 47 further comprising converting (930) the sensed emission data to digital emission data after receiving (920) the sensed emission data at the computer device (600).

51. A method according to any one of claims 37 to 50 further comprising separating (850) the digital emission data into sub-threshold digital emission data (367) and super-threshold digital emission data (366).

52. A method according to claim 51 further comprising a threshold signal intensity (365) separating the sub-threshold digital emission data (367) from the super-threshold digital emission data (366).

53. A method according to claim 52 further comprising transmitting (890) the digital emission data to the computer device (600) in response to the threshold signal intensity (365).

54. A method according to claim 51, 52 or 53 further comprising transmitting (890) the super-threshold digital emission data (366) to the computer device (600).

55. A method according to claim 51, 52, 53 or 54 further comprising buffering (860) at least a portion of the sub-threshold digital emission data (367).

56. A method according to claim 51, 52, 53 or 54 further comprising transmitting (890) at least a portion of the sub-threshold digital intensity data (367) to the computer device (600).

57. A method according to any one of claims 37 to 56 further comprising at least one of compressing, encoding, and encrypting (880) the digital emission data before processing (940) the digital emission data.

58. A method according to claim 57 further comprising at least one of decompressing, decoding, and decrypting (910) the digital emission data before processing (940) the digital emission data.

59. A method according to any one of claims 37 to 58 wherein processing (940) the digital emission data further comprises processing the digital emission data according to at least one of a power versus time in a frequency band analysis, a static frequency analysis, a joint time-frequency analysis (JTFA), an acoustic analysis, a short time duration analysis, and a short time Fourier transform (STET) analysis so as to produce an intensity result with respect to a reference domain.

60. A method according to claim 59 wherein processing the digital emission data further comprises producing (950) a graphical representation of the intensity result with respect to the reference domain.

61. A method according to claim 59 or 60 wherein processing the digital emission data further comprises identifying (960) a characteristic marker from the intensity result with respect to the reference domain, the characteristic marker corresponding to at least one of the identification indicator, the operational characteristic indicator, and the accessory characteristic indicator of the source (700).

62. A method according to any one of claims 37 to 61 wherein processing the digital emission data further comprises accessing (970), within a database operably engaged with the computer device (600), a characteristic marker corresponding to at least one of an identification indicator, an operational characteristic indicator, and an accessory characteristic indicator for each of a plurality of known sources.

63. A method according to claim 62 wherein processing the digital emission data further comprises determining (980) a common reference frame between a characteristic marker of the source (700) and the characteristic marker of each of the plurality of known sources in the database using at least one of a correlation analysis, an interpolation analysis, and an extrapolation analysis.

64. A method according to claim 62 or 63 wherein processing the digital emission data further comprises comparing (990) a characteristic marker of the source (700) with the characteristic marker of each of the plurality of known sources in the database within a common reference frame so as to determine (1010) a best-match known source in the plurality of known sources.

65. A method according to claim 64 wherein processing the digital emission data further comprises performing (1010) a redundancy comparison between the source (700) and the plurality of known sources in the database so as to verify the best-match known source.

66. A method according to claim 62 wherein processing the digital emission data further comprises comparing (990) at least one of the identification indicator, the operational characteristic indicator, and the accessory characteristic indicator of the source (700) with the corresponding at least one of the identification indicator, the operational characteristic indicator, and the accessory characteristic indicator of each of the plurality of known sources in the database so as to identify (1010) a best-match known source in the plurality of known sources.
